# FASCICULE DE BREVET EUROPEEN

(11) **EP 2 692 032 B1**
(45) Date de publication et mention de la délivrance du brevet: **09.08.2017**
(21) Numéro de dépôt: 12707785.7
(22) Date de dépôt: 09.03.2012
(51) Int. Cl.: H01S 5/14, H01S 3/063, H01S 3/094, H01S 3/0941, H01S 3/109, H01S 3/23, H01S 5/10

(54) **SYSTEME D'EMISSION DE SIGNAL OPTIQUE**
SYSTEM ZUR ÜBERTRAGUNG VON OPTISCHEN SIGNALEN
SYSTEM FOR TRANSMITTING OPTICAL SIGNALS

(30) Priorité: 31.03.2011 FR 1100956
(43) Date de publication de la demande: 05.02.2014
(73) Titulaire: THALES, 92400 Courbevoie (FR)
(72) Inventeur: NAPPEZ, Thomas, F-38170 Seyssinet-Pariset (FR); RONDEAU, Philippe, F-26400 Allex (FR); SCHLOTTERBECK, Jean-Pierre, F-26300 Rochefort-Samson (FR); GHIBAUDO, Elise, F-38000 Grenoble (FR); BROQUIN, Jean-Emmanuel, F-38000 Grenoble (FR)
(74) Mandataire: Brunelli, Gérald
(86) Numéro de dépôt international: PCT/EP2012/054167
(87) Numéro de publication internationale: WO 2012/130593

(56) Documents cités:
- EP-A2- 0 644 636
- US-A- 5 513 196
- US-A- 5 867 623
- US-A1- 2003 210 725
- V. DONZELLA ET AL: "Ion-exchanged Er^3+/Yb^3+ co-doped waveguide amplifiers longitudinally pumped by broad area lasers", OPTICS EXPRESS, vol. 18, no. 12, 28 mai 2010 (2010-05-28), page 12690, XP055014043, DOI: 10.1364/OE.18.012690
- LYDIE ONESTAS ET AL: "980nm-1550nm vertically integrated duplexer for hybrid erbium-doped waveguide amplifiers on glass", PROCEEDINGS OF SPIE, 1 janvier 2009 (2009-01-01), pages 721805-1-721805-13, XP055013876, DOI: 10.1117/12.811381

## Description

La présente invention porte sur un système d'émission de signal optique.

L'augmentation continuelle des besoins en capacité de transmission des systèmes de télécommunications optiques a conduit à l'élaboration de dispositifs toujours plus complexes. Le multiplexage en longueur d'ondes associé à l'amplification optique large-bande ont permis d'obtenir des débits dépassant le térabit par seconde. Des sources laser calibrées à haute cohérence sont nécessaires afin d'augmenter la densité d'informations. Les spécifications de ces sources, réalisées selon différentes technologies, sont d'être compactes et intégrées, mono-modes et mono-fréquences, à faible bruit et avoir une bonne stabilité thermique et acoustique.

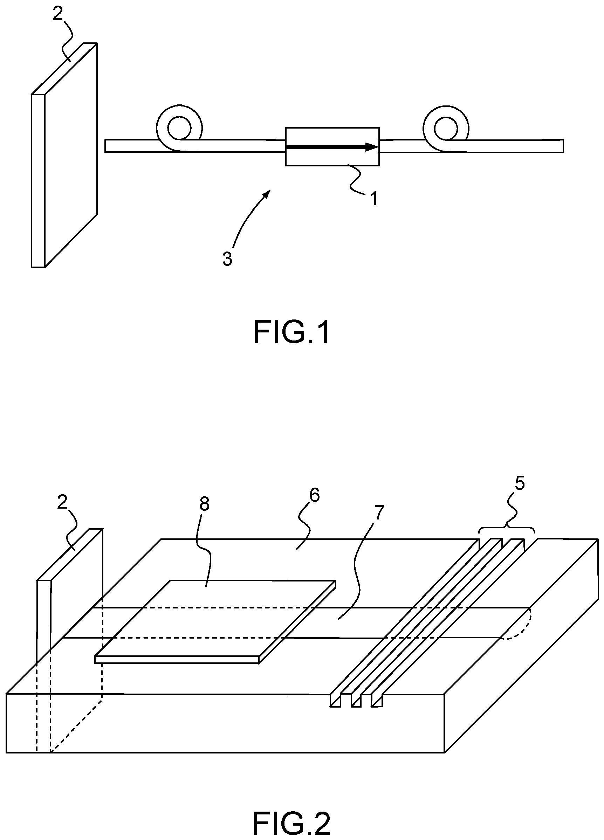

Les lasers à semi-conducteurs, du fait de leur gain élevé et de leur taille réduite sont particulièrement intéressants. Le dimensionnement de la taille verticale de l'hétérojonction et du contact électrique horizontal assure une émission monomode tandis que l'utilisation de résonateurs adaptés assure un comportement mono-fréquence. Cependant ces composants sont très sensibles aux différentes réflexions pouvant être occasionnées le long de la ligne de transmission. La rétroaction optique au sein du laser perturbe ce dernier et augmente fortement son bruit d'intensité relatif. Une solution classique, telle qu'illustrée sur la figure 1 est de placer un isolateur optique 1 permettant un seul sens de circulation du signal optique, après la facette de sortie d'une diode laser 2, sur la ligne de transmission 3 pour éviter toute rétro-injection de lumière au sein de la cavité laser. Une étude validant ces composants pour les applications télécoms a été réalisée par K. Petermann et al. dans 'Noise distortion characteristics of semiconductor lasers in optical fiber communication systems', IEEE J. Quant. Electron., Vol.18, p.543, 1982.

Un autre point faible d'une telle architecture est sa sensibilité aux variations de température. Le coefficient de dilatation thermique élevé des semi-conducteurs nécessite d'ajouter une stabilisation en température pour la plupart des applications. Elle peut prendre la forme d'un fluide passant à proximité de la zone active comme dans le brevet américain US 5903583 ou prendre la forme d'un module Peltier stabilisant la température selon une consigne déterminée, comme proposé dans le brevet américain US 6826916. Cette stabilisation nécessite un support mécanique et une alimentation électrique. Cela baisse l'intégration et augmente fortement le coût du dispositif.

Une solution est d'utiliser pour l'émission laser un matériau actif possédant un coefficient de dilatation thermique plus faible que celui des constituants des diodes lasers, i.e. les alliages ternaires ou quaternaires de semi-conducteurs. Un matériau est dit actif lorsqu'il permet de modifier soit la longueur d'ondes d'un signal (e.g. effet laser, doublement de fréquence), soit d'augmenter l'amplitude d'un signal (e.g. amplificateur). Par opposition, un matériau passif se contente de guider la lumière (de manière rectiligne ou en la faisant tourner) ou de la filtrer (filtre spatial, fréquentiel ou modal)

Le verre est le matériau le plus adapté. Il possède en effet un coefficient de dilatation thermique environ huit fois moins élevé que ceux des semi-conducteurs tout en étant un matériau de choix pour l'optique intégrée. Il est connu des architectures fibrées et planaires. S.A. Babin et al. dans 'Single frequency single polarization DFB fiber laser', Laser Phys. Lett., Vol.4, p.428, 2007, font la démonstration expérimentale d'un laser DFB fibré, pour "Distributed FeedBack" en langue anglaise, est un laser pour lequel la région active est périodiquement structurée comme un réseau de Bragg. Ce réseau crée le résonateur optique du laser, assurant une émission monomode et mono-fréquence stable. J. Zhang et al. dans 'Stable single-mode compound-ring erbium-doped fiber laser', J. Light. Techn., Vol. 14, p. 104, 1996, utilisent une cavité double entièrement fibrée. Ayant chacune leur résonance propre, les cavités composées permettent une émission mono-fréquence grâce à l'effet Vernier. Concernant l'optique intégrée planaire, S. Blaize et al. dans 'Multiwavelengths DFB waveguide laser arrays in Yb-Er codoped phosphate glass substrate', Phot. Techn. Lett., Vol.15, p.516, 2003, ont réalisé des lasers DFB dans un substrat de verre actif présentant les caractéristiques d'émission lumineuse souhaitées.

Les deux architectures, fibrées et planaires, souffrent cependant toutes deux d'un manque de compacité. L'apport de l'énergie nécessaire au fonctionnement du milieu actif nécessite des dispositifs de couplage supplémentaires. En effet, cette énergie est le plus souvent générée par une diode laser, dite de pompe. Il faut alors injecter cette puissance dans le milieu actif. Ceci implique l'utilisation d'optiques de volume ou de guides d'ondes lentillés afin de réduire les fortes pertes par couplage entre la diode laser et le guide d'ondes sur verre. Les optiques de volumes sont les éléments agissant sur la lumière qui ne sont pas intégrés sur une puce ou collés en bout des fibres optiques; elles impliquent donc une propagation de la lumière en espace libre sur des distances non négligeables. Un guide d'ondes lentillé est un guide d'ondes dont la facette est modifiée de manière à réduire la divergence lumineuse en sortie du guide. Cela concerne en grande majorité les fibres optiques dont on peut polir ou graver les extrémités selon une géométrie donnée. Les diodes laser ont un saut d'indice, i.e. une forte différence entre l'indice de réfraction du substrat et du coeur du guide. Les champs sont donc fortement divergents, à la différence des technologies sur verre, où le contraste d'indice est plus faible. Le couplage est aussi réduit du fait de l'astigmatisme de la diode laser. Leur alignement est complexe, la stabilité aux vibrations mauvaise car les composants ne forment pas un bloc monolithique. De plus, la séparation de la longueur d'ondes de pompe de celle du signal en sortie du laser nécessite encore un composant, réalisé dans un matériau passif, différent de celui du milieu actif.

Une meilleure solution peut consister à combiner l'émission lumineuse à haut rendement d'une diode laser avec la stabilité thermique inhérente au verre. Le principe est de créer un résonateur externe à une diode laser. La rétroaction externe, sélective en longueur d'ondes, verrouille la diode laser. C.A. Park et al. dans "Single-mode behaviour of a multimode 1.55 µm laser with a fibre grating external cavity', Electron. Lett., Vol.22, p.1132, 1986, utilise une fibre optique comportant un réseau de Bragg pour verrouiller la diode laser. Ils obtiennent ainsi une émission mono-fréquence stable entre 20°C et 50°C sans stabilisation active de température. Le couplage optique entre la diode laser et la fibre se fait grâce à des optiques de volume. Un dispositif planaire, plus compact, a été proposé par T. Tanaka et al. dans 'Integrated external cavity laser composed of spot-size converter LD and UV written grating in silica waveguide on Si', Electron. Lett., Vol.32, p.1202, 1996. Il comporte un dispositif planaire de couplage entre la diode et le guide planaire suivi d'un réseau de Bragg, tous deux intégrés sur une puce optique. Toute optique de volume pour coupler le champ de la diode laser dans le guide d'ondes est ainsi supprimée. Ces composants, robustes, souffrent, tout comme leurs équivalents fibrés, de la perte de puissance disponible en sortie du dispositif. En effet, pour verrouiller la diode laser, la rétroaction externe doit être suffisamment forte pour vaincre à la fois la cavité initiale et les pertes occasionnées dans la cavité externe. Cette dernière ne laisse donc s'échapper qu'une faible portion du signal et l'obtention de puissance élevée est rendue difficile.

La puissance peut, par exemple, être augmentée en utilisant une diode laser à ruban large. La puce optique sur verre comporte alors une zone large, placée en bout de la diode laser, suivie d'une partie étroite. Une transition adiabatique les relie. La cavité externe est fermée partiellement grâce à une structure réfléchissante intégrée sur la partie étroite. Cette rétroaction verrouille alors l'émission de la diode laser sur les modes supportés par la partie étroite. La rétroaction modifie l'émission modale de la diode plutôt que son émission spectrale. Néanmoins, le problème de la perte de puissance utile en sortie, occasionnée par la forte rétroaction externe, reste à résoudre. Des traitements en anti-réflexion sur la facette de sortie de la diode laser peuvent alors être utilisées afin d'ouvrir la cavité de la diode laser et donc de la verrouiller plus facilement. Cependant le coût des diodes laser traitées en anti-réflexion est très élevé.

V. DONZELLA et al. dans 'Ion-exchanged Er3+/Yb3+ co-doped waveguide amplifiers longitudinally pumped by broad area lasers', OPTICS EXPRESS, Vol. 18, p. 12690, 2010 divulgue un système d'émission de signal optique selon le préambule de la revendication 1. Un but de l'invention est de pouvoir utiliser l'ensemble de la puissance présente dans la cavité externe sans traitement anti-réflexion tel que mentionné ci-dessus.

Un autre but de l'invention est de réaliser une cavité externe planaire à une diode laser et d'y intégrer des éléments actifs de manière monolithique.

Un autre but de l'invention est d'obtenir une émission mono-mode et mono-fréquence grâce à un dispositif interfacé entièrement planaire.

Un autre but de l'invention est de créer un module laser monolithique sans fibres optiques ni optiques de volume.

Un autre but de l'invention est de créer un module d'amplification optique monolithique sans fibres optiques ni optiques de volume.

Il est proposé, selon un aspect de l'invention, un système d'émission de signal optique comprenant une puce optique passive et une diode laser disposée en bordure de ladite puce optique passive pour générer l'émission d'un onde de pompe, ladite puce optique passive étant munie d'un guide d'ondes en surface supérieure, traversant ladite puce optique passive, relié à la sortie de ladite diode laser ladite puce optique passive étant, en outre, recouverte d'une portion en couche mince, active et alimenté par ladite diode laser, pour l'émission du signal optique, par ailleurs selon l'invention:
- ladite puce optique passive étant munie, en outre, d'une structure réfléchissante en surface supérieure, le guide d'ondes traversant ladite structure réfléchissante;
- ladite couche mince recouvrant une partie dudit guide d'ondes entre ladite diode laser et ladite structure réfléchissante; et
- la différence de longueur d'ondes entre ladite diode laser et le signal permettant la structure réfléchissante de n'agir que sur la pompe.

Un tel système d'émission de signal optique permet d'utiliser l'ensemble de la puissance présente dans la cavité externe sans traitement coûteux anti-réflexion de la diode laser, de réaliser une cavité externe planaire à une diode laser et d'y intégrer des éléments actifs de manière monolithique, le tout à coût réduit.

Dans un mode de réalisation, ledit système comprend, en outre, un séparateur de signaux adapté pour séparer l'onde de pompe résiduelle de ladite diode laser du signal du guide d'ondes en sortie de ladite portion en couche mince.

Ainsi, le signal est directement isolé de la pompe résiduelle en sortie du dispositif.

Selon un mode de réalisation, ledit séparateur comprend un duplexeur à couplage adiabatique, un interféromètre de Mach-Zehnder, un interféromètre à modes multiples ou un dispositif à fuite.

Dans un mode de réalisation, ladite diode laser est à ruban large, et la portion du guide d'ondes située entre ladite diode laser et la portion en couche mince comprend un épanouisseur.

Un épanouisseur est défini comme une partie étant une transition adiabatique entre une entrée large du guide d'ondes disposée en sortie de la diode laser et une portion étroite du guide d'ondes.

Ainsi, la puissance de pompe est, à moindre coût, fortement augmentée.

Par exemple, ledit épanouisseur peut être, au moins par morceaux, défini par des fonctions linéaires, hyperboliques, paraboliques, exponentielles, polynômiales, sinusoïdales, ou en arc de cercle.

La taille du dispositif peut donc être réduite.

Selon un mode de réalisation, ladite portion en couche mince comprend un amplificateur optique et/ou un laser DFB ou DBR, et/ou un polymère.

Ainsi, la portion en couche mince utilise l'ensemble de la puissance de pompe disponible, et l'hybridation possible de différents matériaux offre une grande versatilité d'applications.

Par exemple, lorsque ladite portion en couche mince comprend un amplificateur optique, ledit système peut comprendre, en outre, un mélangeur pompe/signal formant jonction entre ledit guide d'ondes en entrée de ladite portion en couche mince, et un guide d'ondes additionnel pour un signal d'entrée, pour recevoir en entrée le signal à amplifier.

Par exemple, ledit mélangeur peut comprendre un duplexeur à couplage adiabatique, un interféromètre de Mach-Zehnder, un interféromètre à modes multiples ou un dispositif à fuite.

Par exemple, ladite structure réfléchissante comprend un réseau de Bragg, un cristal photonique, ou un dispositif de rétroaction planaire.

L'invention sera mieux comprise à l'étude de quelques modes de réalisation décrits à titre d'exemples nullement limitatifs et illustrés par les dessins annexés sur lesquels :
- la figure 1 illustre schématiquement un mode de réalisation connu pour empêcher les réflexions pouvant être occasionnées le long de la ligne de transmission ; et
- les figures 2, 3, 4 et 5 illustrent des systèmes d'émission de signal optique, selon des aspects de l'invention.

Sur l'ensemble de figures, les éléments ayants les mêmes références sont similaires.

Tel qu'illustré sur les figures 2 à 5, un système d'émission de signal optique selon un aspect de l'invention comprend une diode laser 2 qui n'est pas utilisée comme source d'émission de signal mais comme pompe, ou, en d'autres termes comme source d'énergie apportée au milieu actif intégré à l'intérieur de la cavité externe. La différence de longueur d'ondes entre la pompe et le signal permet à une structure réfléchissante 5 de n'agir que sur la pompe. Elle n'occasionne alors pas de pertes pour le signal.

Sur la figure 2, le système d'émission de signal optique comprend une puce optique passive 6 et une diode laser 2 disposée en bordure de la puce optique passive 6. La puce optique passive 6 est munie d'une structure réfléchissante 5 en surface supérieure, et d'un guide d'ondes 7 en surface supérieure, traversant ladite puce optique passive 6, relié à la sortie de ladite diode laser 2 et traversant ladite structure réfléchissante 5. La puce optique passive 6 comprend également une portion en couche mince 8, active ou non-linéaire et alimenté par la diode laser 2, recouvrant une partie dudit guide d'ondes 7, entre la diode laser 2 et la structure réfléchissante 5.

Le système d'émission de signal comporte deux puces optiques 2 et 6 collées en bout. La première est un laser à semi-conducteur 2 dont la face arrière a subi un traitement à haute réflectivité tandis la face avant peut avoir été, ou non, traitée en anti-réflexion. La seconde puce optique passive 6, dont les faces d'entrée et de sortie peuvent avoir été ou non polies avec un angle, et la couche mince active 8 est monolithiquement intégrée sur la face supérieure. Il s'agit donc d'un système hybride, comportant à la fois des éléments passifs et des éléments actifs.

La puissance lumineuse de la diode laser 2 couplée dans le guide d'ondes 7 apporte l'énergie nécessaire au fonctionnement du composant actif 8. La zone active est délimitée par l'extension spatiale de la portion du guide d'ondes 7 recouverte par la couche mince active 8. Cette dernière peut être assemblée sur le substrat 6 par report de plaque ou par toutes techniques de dépôt ou de croissance de couches minces. Le guide d'ondes 7 est présent sous la couche mince active 8 reportée sur l'ensemble ou système dit hybride.

La formation de couche mince 8 au dessus du guide d'ondes passif 7 permet de réaliser un guidage hybride, dans lequel la lumière se situe à la fois dans les milieux passifs et actifs. La portion en couche mince 8, monolithiquement intégrée à la puce passive 6 est reliée à la diode laser 2 grâce au guide de couplage dédié 7. Le système est dimensionné de manière à obtenir une efficacité de couplage élevée, à la fois avec la diode laser 2 et avec le guide hybride formé par la portion du guide 7 situé en dessous de la couche mince 8. Les différentes portions du guide d'ondes 7 sont réalisées selon le même et unique procédé technologique, ce qui supprime les problèmes d'alignement et réduit fortement les coûts de fabrication. Plus la portion du guide d'ondes 7 en interaction avec la structure réfléchissante 5 est longue, plus la réflexion est forte en sortie du guide hybride suivi de la structure réfléchissante 5, dimensionnée pour réfléchir efficacement la longueur d'ondes de la diode laser 2 tout en laissant s'échapper le signal émis par la portion en couche mince 8 active ou non-linéaire. La structure réfléchissante 5 ferme la cavité externe à la diode laser 2.

Un autre avantage de la structure réfléchissante 5 est de recycler la puissance de pompe non utilisée par la zone active ou non-linéaire 8 sur aller simple.

La portion en couche mince 8 active ou non-linéaire peut comporter un réseau de Bragg, interagissant avec la puissance guidée dans la partie du guide d'ondes 7 recouverte par la portion en couche mince 8 active ou non-linéaire. Un laser DFB peut ainsi être créé au sein de la cavité externe à la diode laser 2. Dans le cas où l'application envisagée concerne une émission laser monomode, les portions du guide d'ondes 7 situées entre la diode laser 2 et la sortie de la portion en couche mince 8 active ou non-linéaire sont monomodes à la longueur d'onde du signal.

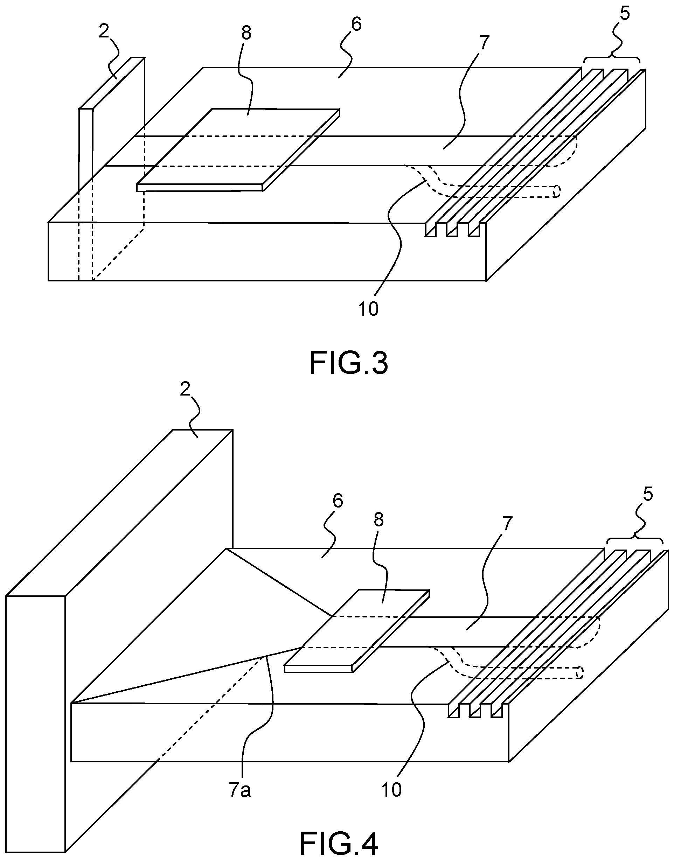

Dans cette optique, la figure 3 illustre une variante dans laquelle le système d'émission de signal optique comprend également l'intégration d'un composant de séparation 10 adapté pour séparer l'onde de pompe de la diode laser 2 du signal du guide d'ondes 7 en sortie de la portion en couche mince 8. Le composant de séparation 10 est un composant passif permettant de séparer deux longueurs d'ondes. Il comporte une portion de guide d'ondes d'entrée 7 et deux guides d'ondes de sortie, la sortie du guide d'ondes 7 et la partie de sortie du guide d'ondes 10 secondaire. La portion du guide d'ondes 7 en sortie de la portion en couche mince 8 est la portion d'entrée du séparateur 10. Elle contient la pompe résiduelle et le signal. Les guides d'ondes de sortie sont la partie du guide d'ondes de sortie 7 qui ne contient plus que le signal de pompe et la portion de guide d'ondes de sortie 10, qui porte le signal en sortie du laser hybride constitué par la portion en couche mince 8 active ou non-linéaire et la portion du guide 7 située en dessous de la couche mince.

Sur la figure 3, un exemple de duplexeur à couplage adiabatique intégré verticalement peut être celui developpé par L. ONESTAS et al. dans '980nm-1550nm vertically integrated duplexer for hybrid erbium-doped waveguide amplifiers on glass', Proc. Of SPIE, vol. 7218-05, 2009. Le guide d'ondes de sortie de la puce passive 6 est donc le guide secondaire ou séparateur 10 qui collecte le signal sans la pompe. Cette dernière, se propageant dans la portion du guide d'ondes 7 en sortie de la portion en couche mince 8, est réfléchie par la structure réfléchissante 5 et stabilise la diode laser 2. Le composant séparateur 10 peut être un duplexeur à couplage adiabatique, comme une jonction Y asymétrique, un interféromètre à modes multiples, un interféromètre de Mach-Zehnder, un dispositif à fuite, ou tout autre dispositif présentant une bonne isolation entre les deux longueurs d'onde.

Une architecture alternative, représentée sur la figure 4, permet d'utiliser une diode laser à ruban large 2 comme source d'énergie pour le laser DFB. Cela permet d'obtenir une puissance de pompe beaucoup plus importante. L'inconvénient de ces rubans est un faisceau large et multi-mode dans la direction horizontale, incompatible avec la forme du signal au sein des lasers intégrés monomodes. En ce cas, la portion de couplage 7a du guide d'ondes 7 prend alors la forme d'un épanouisseur. Un épanouisseur est un guide d'ondes dont la largeur varie le long de son axe. C'est un filtre modal dans la direction transverse: d'une structure large et multimode on passe à une structure étroite et adaptée au guide hybride. La largeur de l'épanouisseur 7a passe au cours de la propagation de la taille du ruban de la diode laser 2 à la dimension du guide d'ondes 7 du laser. Il assure ainsi un rôle de filtrage des modes non désirés. Seul le mode ou les modes nécessaires sont guidés au sein de la portion du guide d'ondes 7 recouvert par la portion en couche mince 8, ce qui assure une utilisation optimale de l'onde de pompe. La forme de l'épanouisseur peut être, par exemple, définie entièrement ou par morceaux, par un fonction linéaire, hyperbolique, parabolique, exponentielle ou polynômiale, de manière à minimiser sa longueur. Un enroulement de la portion du guide d'ondes 7 recouvert par la portion en couche mince 8 peut être envisagée afin d'augmenter la compacité du système. Pour éviter les pertes sur les modes d'ordres supérieurs au sein de l'épanouisseur 7a, la structure réfléchissante 5, traversée par une portion du guide d'ondes 7 assure une rétroaction sur les modes du guide 7 uniquement au sein de la diode laser à ruban large 2. Si le résonateur est principalement défini par cette réflexion et par la facette arrière de la diode laser 2, les modes filtrés par l'épanouisseur 7a subissent trop de pertes pour pouvoir dépasser le seuil laser. La diode laser 2 ainsi rétroagie ne fonctionne donc que sur les modes supportés par le guide 7, évitant toutes pertes de fonction au sein du guide de couplage 7a. La rétroaction 5 peut être réalisée par un réseau de Bragg, comme schématisé sur les figures 2, 3, 4 et 5, par un cristal photonique, ou toute autre structure permettant une rétroaction optique. Le séparateur intégré 10 assure la séparation de la pompe du signal, qui peut être collecté dans le guide d'ondes de sortie 10.

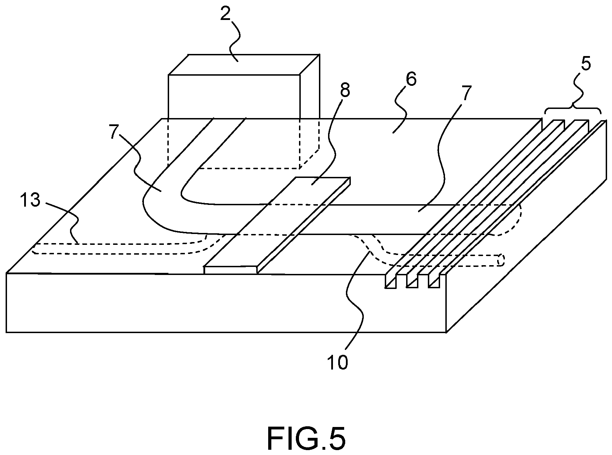

La figure 5 donne un exemple d'une autre application envisagée à l'utilisation d'une portion en couche mince 8 comme amplificateur, i.e. un matériau actif, au sein d'une cavité externe à une diode laser 2. Elle concerne un amplificateur optique entièrement interfacé en optique intégrée planaire. La puissance de pompe est produite par une diode laser 2 et amenée à l'amplificateur, formé par la portion en couche mince 8 et la portion du guide d'ondes 7 qu'elle recouvre, grâce au guide d'ondes 7. Un guide d'ondes additionnel 13 pour un signal d'entrée et la sortie 10 du signal sont reliées à l'amplificateur grâce à deux duplexeurs : l'un 13 combinant le signal et la pompe en entrée, l'autre 10 les séparant en sortie. La portion en couche mince 8 active ou non-linéaire reportée sur la puce passive 6 forme un guidage hybride (formé par la portion en couche mince 8 et la portion du guide d'ondes 7 qu'elle recouvre) dans lequel l'amplification du signal arrivant par le guide d'ondes 13 prend place. Ce dispositif est particulièrement adapté pour les répéteurs entièrement optiques dans les liaisons de télécommunications. Des fibres optiques sont alors placées en bout des guides d'ondes 13 et 10. La portion du guide d'ondes 7 recouvert par la portion en couche mince 8 peut être enroulée sur elle-même afin d'augmenter la longueur de l'amplificateur sans perdre en compacité.

## Revendications

1. Système d'émission de signal optique comprenant une puce optique passive (6) et une diode laser (2) disposée en bordure de ladite puce optique passive (6) pour générer l'émission d'une onde de pompe, ladite puce optique passive (6) étant munie d'un guide d'ondes (7) en surface supérieure, traversant ladite puce optique passive (6), relié à la sortie de ladite diode laser (2) ladite puce optique passive étant, en outre, recouverte d'une portion en couche mince (8), active et alimenté par ladite diode laser (2), pour l'émission du signal optique, **caractérisé en ce que** :
- ladite puce optique passive (6) étant munie, en outre, d'une structure réfléchissante (5) en surface supérieure, le guide d'ondes traversant ladite structure réfléchissante (5);
- ladite couche mince recouvrant une partie dudit guide d'ondes (7) entre ladite diode laser (2) et ladite structure réfléchissante (5); et
- la différence de longueur d'ondes entre ladite diode laser (2) et le signal permettant la structure réfléchissante (5) de n'agir que sur la pompe.

2. Système selon la revendication 1, comprenant, en outre, un séparateur (10) de signaux adapté pour séparer l'onde de pompe résiduelle de ladite diode laser (2) du signal du guide d'ondes (7) en sortie de ladite portion en couche mince (8).

3. Système selon la revendication 2, dans lequel ledit séparateur (10) comprend un duplexeur à couplage adiabatique, un interféromètre de Mach-Zehnder, ou un dispositif à fuite.

4. Système selon l'une des revendications précédentes, dans lequel ladite diode laser (2) est à ruban large, et la portion du guide d'ondes (7) située entre ladite diode laser (2) et la portion en couche mince (8) comprend un épanouisseur (7a).

5. Système selon la revendication 4, dans lequel ledit épanouisseur (7a) est, au moins par morceaux, défini par des fonctions linéaires, hyperboliques, paraboliques, exponentielles, polynômiales, sinusoïdales, ou en arc de cercle.

6. Système selon l'une des revendications précédentes, dans lequel ladite portion en couche mince (8) comprend un amplificateur optique et/ou un laser DFB ou DBR, et/ou un polymère.

7. Système selon la revendication 6, dans lequel, ladite portion en couche mince (8) comprenant un amplificateur optique, ledit système comprend, en outre, un mélangeur pompe/signal (13) formant jonction entre ledit guide d'ondes (7) en entrée de ladite portion en couche mince, et un guide d'ondes (13) additionnel pour un signal d'entrée, pour recevoir en entrée le signal à amplifier.

8. Système selon la revendication 7, dans lequel ledit mélangeur (13) comprend un duplexeur à couplage adiabatique, un interféromètre de Mach-Zehnder, un interféromètre à modes multiples ou un dispositif à fuite.

9. Système selon l'une des revendications précédentes, dans lequel ladite structure réfléchissante (5) comprend un réseau de Bragg, un cristal photonique, ou un dispositif de rétroaction planaire.

## Patentansprüche

1. System zum Übertragen von optischen Signalen, umfassend einen passiven optischen Chip (6) und eine Laserdiode (2), die am Rand des passiven optischen Chips (6) angeordnet ist, um die Übertragung einer Pumpenwelle zu erzeugen, wobei der passive optische Chip (6) über eine Wellenführung (7) an der oberen Fläche verfügt, die den passiven optischen Chip (6) durchquert, und die mit dem Ausgang der Laserdiode (2) verbunden ist, wobei der passive optische Chip (6) außerdem mit einem aktiven Dünnschichtabschnitt (8) abgedeckt ist, die von der Laserdiode (2) zum Übertragen des optischen Signals abgedeckt ist, **dadurch gekennzeichnet, dass**:
- der passive optische Chip (6) außerdem über eine reflektierende Struktur (5) an der oberen Fläche verfügt, wobei die Wellenführung die reflektierende Struktur (5) durchquert;
- die dünne Schicht einen Teil der Wellenführung (7) zwischen der Laserdiode (2) und der reflektierenden Struktur (5) abdeckt; und
- die Differenz der Wellenlänge zwischen der Laserdiode (2) und dem Signal der reflektierenden Struktur (5) ermöglicht, nur auf die Pumpe zu wirken.

2. System nach Anspruch 1, umfassend außerdem einen Signaltrenner (10), der angepasst ist, um die residuale Pumpenwelle der Laserdiode (2) vom Signal der Wellenführung (7) am Ausgang des Dünnschichtabschnitts (8) zu trennen.

3. System nach Anspruch 2, wobei der Trenner (10) einen Duplexer mit adiabatischer Kopplung, einen Mach-Zehnder-Interferometer oder eine Ableitvorrichtung umfasst.

4. System nach einem der vorherigen Ansprüche, wobei die Laserdiode (2) ein breites Band ist und der Abschnitt der Wellenführung (7) zwischen der Laserdiode (2) und dem Dünnschichtabschnitt (8) eine Bördelung (7a) umfasst.

5. System nach Anspruch 4, wobei die Bördelung (7a) mindestens stückweise durch lineare, hyperbolische, parabolische, exponentielle, polynomische, sinusförmige oder kreisbogenförmige Funktionen definiert ist.

6. System nach einem der vorherigen Ansprüche, wobei der Dünnschichtabschnitt (8) einen optischen Verstärker und/oder einen DFB- oder DBR- Laser und/oder ein Polymer umfasst.

7. System nach Anspruch 6, wobei, der Dünnschichtabschnitt (8) umfassend einen optischen Verstärker, das System außerdem einen Pumpe/Signal Mischer (13) umfasst, der eine Verbindung zwischen der Wellenführung (7) am Eingang des Dünnschichtabschnitts und einer zusätzlichen Wellenführung (13) für ein Eingangssignal bildet, um das zu verstärkende Signal am Eingang zu empfangen.

8. System nach Anspruch 7, wobei der Mischer (13) einen Duplexer mit adiabatischer Kopplung, einen Mach-Zehnder-Interferometer, einen Multimode-Interferometer oder eine Ableitvorrichtung umfasst.

9. System nach einem der vorherigen Ansprüche, wobei die reflektierende Struktur (5) ein Bragg-Netz, ein Fotonenkristall oder eine planare Rückkopplungsvorrichtung umfasst.

## Claims

1. System for transmitting optical signals comprising a passive optical chip (6) and a laser diode (2) disposed at the edge of said passive optical chip (6) for generating the transmission of a pump wave, said passive optical chip (6) being provided with a waveguide (7) on the upper surface, traversing said passive optical chip (6), connected to the output of said laser diode (2) said passive optical chip (6) being, in addition, covered by a thin-film portion (8), active and fed by said laser diode (2), for transmitting optical signals, **characterised in that**:
- said passive optical chip (6) being provided, in addition, with a reflective structure (5) on the upper surface, the waveguide traversing said reflective structure (5);
- said thin-film portion covering a part of the waveguide (7) between said laser diode (2) and said reflective structure (5); and
- the difference in wavelength between said laser diode (2) and the signal allowing the reflective surface (5) to only act upon the pump.

2. System according to claim 1, comprising, in addition, a signal separator (10) adapted for separating the residual pump wave of said laser diode (2) from the waveguide (7) signal at the output of said thin-film portion (8).

3. System according to claim 2, in which said separator (10) comprises an adiabatic coupling duplexer, a Mach-Zehnder interferometer, or a leakage device.

4. System according to one of the preceding claims, in which said laser diode (2) is a broad stripe, and the portion of the waveguide (7) situated between said laser diode (2) and the thin-film portion (8) comprises a taper (7a).

5. System according to claim 4, in which said taper (7a) is, at least piecewise, defined by linear, hyperbolic, parabolic, exponential, polynomial, sinusoidal functions, or in a circular arc.

6. System according to one of the preceding claims, in which said thin-film portion (8) comprises an optical amplifier and/or a DFB or DBR laser, and/or a polymer.

7. System according to claim 6, in which, said thin-film portion (8) comprising an optical amplifier, said system comprises, in addition, a pump/signal mixer (13) forming a junction between said waveguide (7) at the entrance of said thin-film portion, and an additional waveguide for an input signal (13), for receiving as input the signal to amplify.

8. System according to claim 7, in which said mixer (13) comprises an adiabatic coupling duplexer, a Mach-Zehnder interferometer, a multi-mode interferometer, or a leakage device.

9. System according to one of the preceding claims, in which said reflective structure (5) comprises a Bragg grating, a photonic crystal, or a planar feedback device.
